# DEMANDE DE BREVET EUROPEEN

(11) **EP 4 651 204 A1**
(43) Date de publication de la demande: **19.11.2025**
(21) Numéro de dépôt: 25156138.7
(22) Date de dépôt: 06.02.2025
(51) Int. Cl.: H01L 23/48, H01L 21/78, H01L 23/31

(54) **PROCEDE DE FABRICATION DE COMPOSANTS ELECTRONIQUES A FLANCS MOUILLABLES**

(30) Priorité: 17.05.2024 FR 2405066
(71) Demandeur: STMicroelectronics International N.V., 1228 Plan-les-Ouates, Geneva (CH)
(72) Inventeur: DELACOURT, Grégoire, 37000 TOURS (FR); JOREZ, Benjamin, 37390 CHARENTILLY (FR)
(74) Mandataire: Cabinet Beaumont

(57) **Abrégé**

La présente description concerne un procédé comprenant les étapes suivantes :
a)fournir un substrat (300) dans lequel sont formées des puces (100), des plages de connexion (107)étant disposées sur le substrat (300), des plots conducteurs (117) pouvant recouvrir les plages de connexion (107),
b) optionnellement, former des cavités (307) entre les puces (100),
c) déposer une couche de matériau isolant (121) sur le substrat (300) et dans les cavités (307),
d) rendre accessible les plages de connexion (107) ou les plots conducteurs (117),
e) déposer une couche de matériau conducteur (122) pour relier les plages de connexion de deux puces adjacentes,
f) déposer une couche additionnelle de matériau isolant (123),
g) amincir la couche additionnelle (123) jusqu'à rendre accessible le matériau conducteur (122),
h) séparer les composants électroniques (1000) en à travers à les cavités (307), moyennant quoi le matériau conducteur (122) forme les flancs mouillables des composants électroniques (1000).

## Description

### Domaine technique

La présente description concerne la fabrication de composants électroniques à flancs mouillables. Elle vise plus particulièrement la fabrication de composants dits à montage en surface, dits "leadless", c'est-à-dire sans connexions apparentes une fois assemblés sur la carte électronique. Ces composants comportent, du côté d'au moins une face, une ou plusieurs métallisations de connexion destinées à être brasées à des plages de connexion correspondantes d'un dispositif externe, par exemple une carte de circuit imprimé ou un autre composant.

### Technique antérieure

Dans certaines applications, il existe un besoin pour des composants à montage en surface dans lesquels des métallisations de connexion destinées à être brasées à un dispositif externe s'étendent jusqu'aux flancs des composants. On parle de composants à flancs mouillables (en anglais "wettable flank"). Lors du montage du composant dans son environnement (par exemple, sur une carte de circuit imprimé), les métallisations de connexion (aussi appelées contacts électriques) sont soudées ou brasées à des pistes ou éléments métalliques correspondants côté circuit imprimé. Une partie du matériau de brasage remonte alors sur les flancs des composants, ce qui permet de mettre en oeuvre une inspection visuelle de la qualité des connexions.

Ce besoin existe par exemple dans le domaine automobile ou le domaine médical et, plus généralement, dans les domaines où l'on souhaite s'assurer du bon assemblage des composants dont les connexions ne sont pas visibles (les connexions sont sous le composant) et garantir la fiabilité des connexions électriques, une fois les circuits montés dans leur environnement (technologie dite 'flip-chip').

### Résumé de l'invention

Il existe un besoin d'améliorer au moins en partie certains aspects des procédés connus de fabrication de composants électroniques à flancs mouillables.

Ce but est atteint par un procédé de fabrication de composants électroniques à flancs mouillables comprenant les étapes suivantes :
a) fournir un substrat dans lequel sont formées des puces, des plages de connexion des puces étant disposées sur une face supérieure du substrat, des plots conducteurs pouvant recouvrir les plages de connexion,
b) de manière optionnelle, former des cavités ou des tranchées entre les puces à partir de la face supérieure du substrat,
c) former une première couche de matériau isolant sur le substrat, la première couche de matériau isolant recouvrant la face supérieure du substrat, la première couche de matériau isolant remplissant les cavités ou les tranchées si l'étape b) a été mise en oeuvre,
d) rendre accessible les plages de connexion ou les plots conducteurs,
e) déposer une couche de matériau conducteur de manière à relier les plages de connexion de deux puces adjacentes, la couche de matériau conducteur recouvrant les cavités ou les tranchées si l'étape b) a été mise en oeuvre,
f) déposer une deuxième couche de matériau isolant sur le matériau conducteur et la face supérieure du substrat,
g) amincir la deuxième couche de matériau isolant jusqu'à rendre accessible le matériau conducteur,
h) séparer les puces en découpant à travers la couche de matériau conducteur et à travers la première couche de matériau isolant, la découpe étant réalisée travers les cavités ou les tranchées si l'étape b) a été mise en oeuvre, moyennant quoi on obtient des composants électroniques à flancs mouillables.

Selon un mode de réalisation, lors de l'étape a), les plages de connexion sont recouvertes par des plots conducteurs, et dans le procédé :
- l'étape c) est réalisée en déposant la première couche de matériau isolant sur la face supérieure du substrat et sur les plots conducteurs,
- l'étape d) est réalisée en amincissant la première couche de matériau isolant jusqu'à rendre accessible les plots conducteurs, et
- lors de l'étape e), la couche de matériau conducteur est déposée sur les plots conducteurs.

Selon un mode de réalisation, lors de l'étape a), les plages de connexion ne sont pas recouvertes par des plots conducteurs et dans le procédé :
- l'étape c) est réalisée en déposant la première couche de matériau isolant sur la face supérieure du substrat et sur les plages de connexion,
- l'étape d) est réalisée en en gravant, et éventuellement en amincissant, la première couche de matériau isolant, pour rendre accessible les plages de connexion, et
- lors de l'étape e), la couche de matériau conducteur est déposée sur les plages de connexion.

Selon un mode de réalisation, avant l'étape g), une étape au cours de laquelle une face inférieure du substrat est amincie et est recouverte par une couche additionnelle de matériau isolant.

Selon un mode de réalisation, la première couche de matériau isolant et/ou la deuxième couche de matériau isolant et/ou la couche additionnelle de matériau isolant sont des couches de résine isolante, par exemple des couches de résine époxy.

Ce but est également atteint par un composant électronique à flancs mouillables comprenant une puce formée dans un substrat, la puce comprenant des plages de connexion disposées sur une face supérieure du substrat, une première couche de matériau isolant recouvrant les flancs du substrat et la face supérieure du substrat entre les plages de connexion, une deuxième couche de matériau isolant recouvrant la première couche de matériau isolant sur la face supérieure du substrat, une couche de matériau conducteur étant disposée sur chaque plage de connexion et se prolongeant, d'une part, jusqu'à une face supérieure du composant électronique, et, d'autre part, jusqu'à un flanc du composant électronique.

Selon un mode de réalisation, une couche additionnelle de matériau isolant recouvre une face inférieure du substrat.

Selon un mode de réalisation, la première couche de matériau isolant, la deuxième couche de matériau isolant et/ou la couche additionnelle de matériau isolant est une couche de résine époxy ou phénolique dans laquelle sont dispersées des charges électriquement isolantes, par exemple des particules d'alumine ou de silice.

Selon un mode de réalisation, la couche de matériau conducteur est une couche de matériau brasable, par exemple un matériau brasable à base d'étain, tel que SnAgCu.

Ce but est également atteint par un procédé d'assemblage d'un composant électronique tel que défini précédemment, avec un dispositif externe, tel qu'une carte de circuit imprimé, le procédé comprenant les étapes suivantes :
- positionner un matériau de brasage entre le matériau conducteur positionné sur la face supérieure du composant électronique et des éléments de connexion du dispositif externe,
- braser le matériau de brasage, moyennant quoi le matériau de brasage s'étale sur les éléments de connexion du dispositif externe et sur les flancs mouillables du composant électronique.

Ce but est également atteint par l'utilisation d'un tel composant électronique à flancs mouillables dans une automobile, par exemple dans un système avancé d'aide à la conduite, dans l'électronique personnelle, dans un équipement de communication, tel qu'un ordinateur, un téléphone portable (`smartphone'), un objet connecté (IoT) ou un de leurs périphériques.

Ce but est également atteint par une automobile, un équipement de communication, tel qu'un ordinateur, un téléphone portable (`smartphone'), un objet connecté (IoT) ou un de leurs périphériques comprenant un tel composant électronique à flancs mouillables.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F, la figure 1G, la figure 1H et la figure 1I représentent des vues en coupe illustrant des étapes d'un procédé de fabrication d'un composant électronique à flancs mouillables selon un mode de réalisation particulier ;
la figure 2A, la figure 2B, la figure 2C, la figure 2D, la figure 2E, la figure 2F, la figure 2G, la figure 2H et la figure 2I représentent des vues en coupe illustrant des étapes d'un procédé de fabrication d'un composant électronique à flancs mouillables selon un autre mode de réalisation particulier ;
la figure 3A et la figure 3B représentent des vues en coupe illustrant des étapes d'un procédé d'assemblage d'un composant électronique à flancs mouillables avec un dispositif externe selon un mode de réalisation particulier ;
la figure 4 représente, de manière schématique, une vue en coupe et de profil, d'un composant électronique à flancs mouillables selon un autre mode de réalisation particulier.

Sur les différentes figures, pour faciliter les schémas, les puces peuvent avoir été représentées entièrement ou avoir été tronquées (notamment sous forme de demi-puces).

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

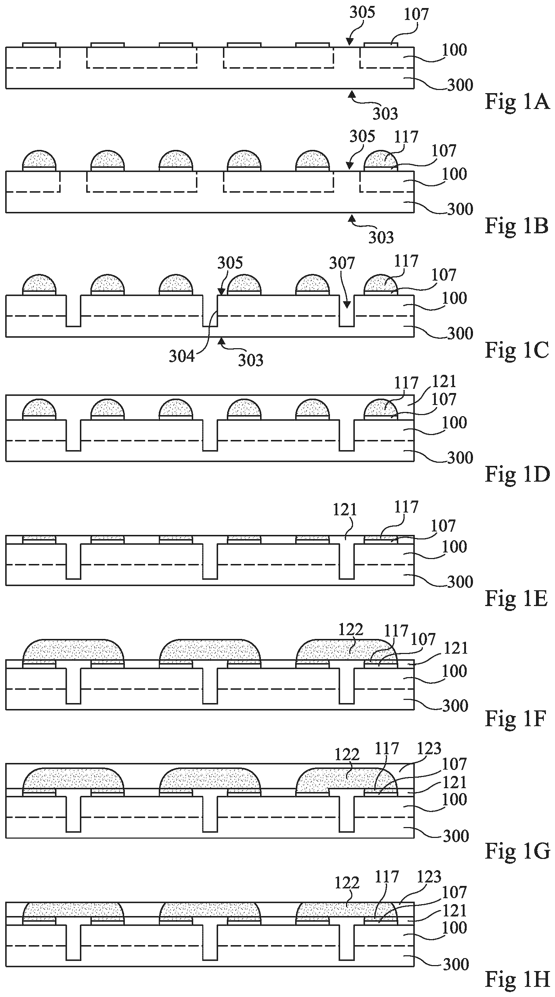

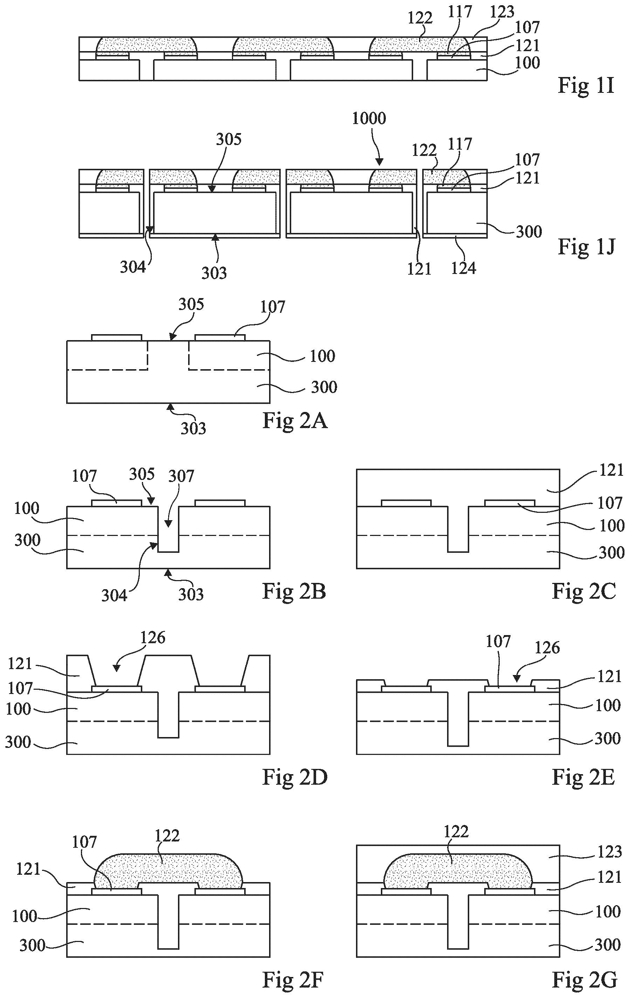

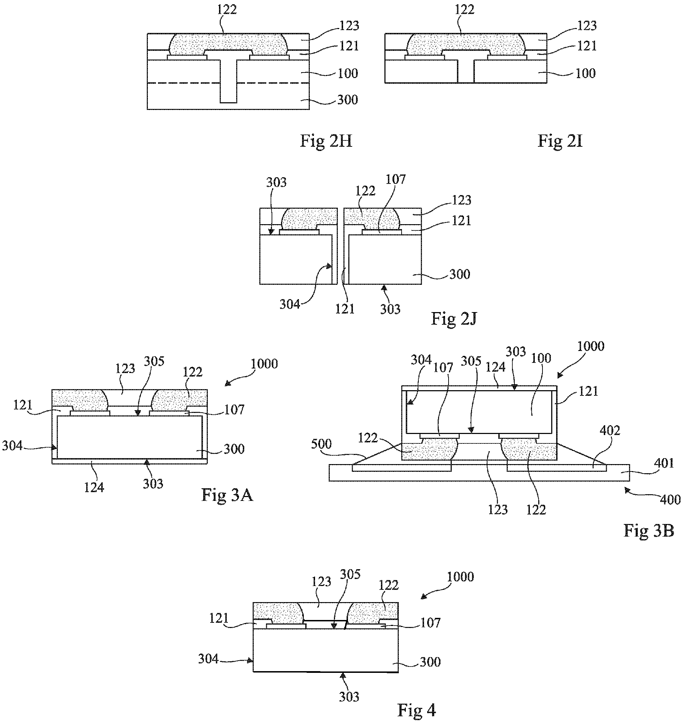

Nous allons maintenant décrire plus en détail le procédé de fabrication d'un composant électronique 1000 à flancs mouillables en faisant référence aux figures 1A à 1I et 2A à 2I.

Le procédé comprend au moins les étapes suivantes :
a)fournir un substrat 300 dans lequel sont formées des puces 100, les puces 100 ayant des plages de connexion 107 disposées sur une face supérieure 305 du substrat 300 (figures 1A, 2A), des plots conducteurs 117 pouvant recouvrir les plages de connexion 107 (figure 1B),
b) former des cavités 307 ou des tranchées entre les puces 100 (figures 1C, 2B),
c) former une première couche de matériau isolant 121 de manière à remplir les cavités 307 ou les tranchées de matériau isolant et recouvrir la face supérieure 305 du substrat 300 entre les plages de connexion 107 (figures 1D, 2C),
d) rendre accessible les plages de connexion 107 (figure 2D) ou les plots conducteurs 117 (figure 1E),
e) déposer une couche de matériau conducteur 122 de manière à recouvrir les cavités 307 ou les tranchées, et en particulier de manière à recouvrir le matériau isolant remplissant les cavités 307 ou les tranchées, et à relier les plages de connexion 107 de deux puces adjacentes 100 (figures 1F, 2F),
f) déposer une deuxième couche de matériau isolant 123 sur le matériau conducteur 122 et sur la face supérieure 305 du substrat 300 (figures 1G, 2G),
g) amincir la deuxième couche de matériau isolant 123 jusqu'à rendre accessible le matériau conducteur 122 (figures 1H, 2H),
h) séparer les puces 100 pour former les composants électroniques 1000, en découpant à travers la couche de matériau conducteur 122 et à travers la cavité 307 ou la tranchée, moyennant quoi le matériau conducteur 122 forme à la fois les connexions électriques et les flancs mouillables des composants électroniques 1000 (figures 1I, 2I).

L'étape b) est une étape facultative. Elle peut être mise en oeuvre ou elle peut ne pas être mise en oeuvre.

La mise en oeuvre de l'étape c) permet de parer à tout défaut électrique (court-circuit, courant de fuite...) entre les connexions ou autre éléments conducteur relié à ces connexions et le flanc des puces en substrat semi-conducteur.

La couche de matériau conducteur 122 déposée lors de l'étape d) forme un pont de matériau conducteur entre deux puces adjacentes. Ce pont relie deux plages de connexion 107 de deux puces adjacentes 100.

Lorsque ce pont est coupé lors de l'étape e), le matériau forme une partie des flancs des composants électroniques 1000. On obtient ainsi des composants 1000 à flancs mouillables.

Avec un tel procédé, la partie formant le flanc mouillable a une hauteur pouvant être facilement adaptée en fonction de l'épaisseur de matériau conducteur 122 déposée. Il est possible d'avoir des parties mouillables d'au moins 100 µm de hauteur.

La présence de la première couche de matériau isolant 121 entre le matériau conducteur 122 et la puce 100 évite les risques de court-circuit. De plus, la présence de ce matériau dans les cavités empêche l'affaissement du matériau conducteur lors de la découpe. Le dispositif obtenu présente une bonne tenue mécanique.

Le procédé peut en outre comprendre, avant l'étape h), une étape au cours de laquelle la face arrière du substrat 300 est amincie et est recouverte par une couche additionnelle de matériau isolant 124.

Lors de l'étape c), la première couche de matériau isolant 121 est, de préférence, déposée pleine plaque sur la face supérieure 305 du substrat 300 puis structurée. Le matériau isolant remplit les cavités 307 et recouvre la face supérieure 305 du substrat 300 entre les plages de connexion 107.

Selon une première variante de réalisation, le substrat 300 fourni à l'étape a) comprend des plots conducteurs 117 recouvrant les plages de connexion 107.

Selon cette première variante de réalisation, par exemple représentée sur les figures 1A à 1I, le procédé peut comprendre au moins les étapes suivantes :
a)fournir le substrat 300 dans lequel sont formées les puces 100, les plages de connexion 107 étant disposées sur la face supérieure du substrat 300 (figure 1A),
   - recouvrir les plages de connexion 107 par des plots conducteurs 117(`wafer bumping') (figure 1B),
b) former les cavités 307 ou les tranchées entre les puces 100 (figure 1C),
c) remplir les cavités 307 ou les tranchées par la première couche de matériau isolant 121, la première couche de matériau isolant 121 recouvrant la face supérieure du substrat 300 et les plots conducteurs 117 (figure 1D),
d) amincir la première couche de matériau isolant 121 jusqu'à rendre accessible une partie des plots conducteurs 117 (figure 1E),
e) déposer la couche de matériau conducteur 122 de manière à recouvrir les cavités 307 ou les tranchées et à relier les plages de connexion 107 de deux puces 100 adjacentes, la couche de matériau conducteur 122 étant en contact avec les plots conducteurs 117 (figure 1F),
f) déposer une deuxième couche de matériau isolant 123 sur le matériau conducteur 122 (figure 1G),
g) amincir la deuxième couche de matériau isolant 132, depuis la face avant, jusqu'à rendre accessible le matériau conducteur 122 (figure 1H),
h) séparer les puces 100 en découpant à travers la couche de matériau conducteur 122 et à travers les cavités 307 ou les tranchées, moyennant quoi le matériau conducteur 122 forme les connexions électriques et les flancs mouillables des composants électroniques 1000 (figure 1I).

Selon une deuxième variante de réalisation, lors de l'étape a), les plages de connexion 107 ne sont pas recouvertes par des plots conducteurs.

Selon cette deuxième variante de réalisation, le procédé peut comprendre les étapes suivantes :
a)fournir le substrat 300 dans lequel sont formées les puces 100, les plages de connexion 107 étant disposées sur la face supérieure 305 du substrat 300 (figure 1A),
b) former les cavités 307 ou les tranchées entre les puces 100 (figure 2B),
c) remplir les cavités 307 ou les tranchées par la première couche de matériau isolant 121, la première couche de matériau isolant 121 recouvrant la face supérieure du substrat 300 et les plages de connexion 107 (figure 2C),
d) rendre accessible les plages de connexion 107, par exemple par gravure laser, et éventuellement en réalisant un amincissement de la face avant (figure 2E),
e) déposer la couche de matériau conducteur 122 de manière à recouvrir les cavités 307 et à relier les plages de connexion 107 de deux puces 100 adjacentes (figure 2F),
f) déposer une deuxième couche de matériau isolant 123 sur le matériau conducteur 122 (figure 2G),
g) amincir la deuxième couche de matériau isolant 123, depuis la face avant, jusqu'à rendre accessible le matériau conducteur 122 (figure 2H),
h) séparer les puces 100 en découpant à travers la couche de matériau conducteur 122 et à travers les cavités 307 ou les tranchées, moyennant quoi le matériau conducteur 122 forme les connexions électriques et les flancs mouillables des composants électroniques 1000 (figure 2I).

Nous allons maintenant décrire plus en détail les différents éléments et étapes des différentes variantes du procédé de fabrication du composant électronique 1000 à flancs mouillables.

La structure de base fournie à l'étape a) comprend une puce électronique 100 formée à partir d'un substrat 300 semiconducteur, par exemple en silicium. Il peut également s'agir de SiC, verre, GaN, ou de saphir.

Le substrat 300 a, par exemple, une épaisseur comprise entre 300 et 1200 µm, par exemple une épaisseur d'environ 725 µm.

Le substrat 300 comprend une première face 305 (face supérieure ou face avant) et une deuxième face 303 (face arrière ou face inférieure).

La puce 100 est formée du côté de la face avant 305 du substrat 300.

La puce 100 peut comprendre un composant discret ou plusieurs composants discrets. Le ou les composants discrets sont, par exemple, choisis parmi les transistors, diodes, filtres, etc. La puce 100 peut comprendre un ou plusieurs circuits électroniques. La puce 100 permet de mettre en oeuvre différentes fonctions électroniques.

A l'étape a), la fabrication du ou des composants discrets et/ou circuits intégrés formant les composants 1000 est achevée. Les puces 100 sont formées dans un même substrat 300, et n'ont pas encore été individualisées.

Une ou plusieurs plages de connexion 107 sont formées sur la face supérieure 305 du substrat 300 pour connecter la puce 100 à des éléments/dispositifs externes 400 (puces ou dispositifs électroniques).

Les plages de connexion électriques 107 sont aussi appelés « UBM » (pour l'expression anglosaxonne « Under Bump Metallization ») ou « bumping pads ». Les plages de connexion électriques 107 sont en un matériau conducteur spécifiquement adapté à recevoir des plots conducteurs 117, et présentant notamment une bonne adhérence avec les plots conducteurs 117. Les plages de connexion électriques 107 comprennent au moins un des éléments suivants : or, titane, nickel, ou cuivre. De préférence, elles comprennent de l'or.

Les plages de connexion électrique 107 sont, par exemple, à une distance de 10 à 30 µm de la paroi latérale de la puce. Les plages de connexion électrique 107 peuvent être positionnées sur la face supérieure 305 du substrat 300 ou affleurer sur la face supérieure 305 du substrat 300 (i.e. arriver au niveau de la face supérieure 305).

Lors de l'étape a), les plages de connexion 107 peuvent avoir une surface supérieure libre (i.e. ne pas être recouvertes, comme représenté sur la figure 2A) ou elles peuvent être recouvertes par des plots conducteurs 117 (comme représenté sur la figure 1B).

Les plots conducteurs 117 peuvent notamment avoir la forme d'une bille (« bump » en terme anglo-saxon). Alternativement, il peut s'agir d'un élément conducteur ayant une autre forme, comme par exemple un pilier ou un cube.

Les plots conducteurs 117 sont formés en un matériau conducteur électriquement et "mouillable" (i.e. brasable ou soudable), c'est-à-dire un matériau sur lequel il est possible de réaliser un brasage.

Les plots conducteurs 117 sont, avantageusement, brasés sur les plages de connexion électrique 107. Par exemple les plots conducteurs sont en un matériau brasable à base généralement d'étain, typiquement SnAgCu.

A ce stade, la puce 100 n'est pas encore protégée par un boîtier en matériau isolant.

Lors de l'étape b), des cavités 307 ou des tranchées (non représentées) sont formées, dans le substrat 300, de manière à séparer les puces 100 adjacentes. Les cavités 307 ou tranchées délimitent les flancs 304 du substrat 300 pour chaque composant 1000.

Les cavités 307 définissant les contours latéraux des puces 100 des composants 100 sont formées dans le substrat 300. Les cavités 307 s'étendent depuis la face supérieure 305 du substrat 300. Selon un exemple, la profondeur des cavités 307 correspond à l'épaisseur voulue des puces des composants 100. Selon un exemple, la profondeur des cavités 307 est de l'ordre de 100 ou 300 µm. La profondeur peut être modifiée en fonction de l'application voulue. Les cavités 307 formées à l'étape b) ont, de préférence, une épaisseur comprise entre 50 et 80 µm. L'épaisseur peut être modifiée en fonction de l'application voulue.

Les tranchées traversent de part en part le substrat. Les tranchées définissent les contours latéraux des puces 100. L'épaisseur des tranchées est, par exemple, comprise entre 20 et 80 µm.

L'étape b) peut être réalisée au moyen d'une étape de découpe/gravure partielle ou totale du substrat. Cette étape peut être réalisée au moyen d'un dispositif de découpe ou de gravure. Le dispositif de découpe est, par exemple, un outil de gravure mécanique comme une scie, ou un outil de gravure par un laser ou plasma. La découpe peut être réalisée avec une lame ou deux lames.

Selon un autre mode de réalisation, il peut s'agir d'une découpe laser (`laser grooving' ou 'laser dicing') ou plasma (`plasma dicing'). Ces différents procédés de découpe peuvent être aussi utilisés en commun.

La formation de l'espace 307 entre les puces 100 peut également être réalisée par une étape de découpe par introduction de dislocation par laser (étape dite de 'stealth dicing') puis une étape d'expansion. L'étape dite de 'stealth dicing' consiste, avec un laser spécifique, à générer des dislocations au sein du substrat, dans les chemins de découpe. Ces dislocations sont des défauts présents dans l'épaisseur du substrat qui, sous l'effet d'une contrainte mécanique, vont permettre de séparer les puces. Il suffit alors d'étirer le support adhésif pour écarter les puces et procéder au dépôt du matériau.

Dans le cas présent, le substrat 300 peut être mis à épaisseur finale du produit avant l'opération de 'stealth dicing'.

Lors de l'étape c), les cavités 307 ou les tranchées sont remplies par une première couche de matériau isolant 121.

La première couche de matériau isolant 121 peut aussi recouvrir la face supérieure du substrat 300.

Pour cela, une couche 121 de matériau isolant est déposée dans les cavités 307, sur la première face 305 du substrat 300. La première couche de matériau isolant 121 recouvre les plages de connexion 107 et, le cas échéant, les plots conducteurs 117. Ces derniers éléments sont, à l'issue de l'étape c), disposés au sein du matériau isolant. La première couche 121 forme une première partie du boîtier des composants 1000. Cette première partie du boîtier protège donc la face supérieure et une partie des flancs des composants 1000.

Le matériau isolant peut être déposé au moyen d'une presse ou par moulage sous vide.

Le matériau isolant peut comprendre une résine isolante électriquement. Il peut s'agir d'une résine thermodurcissable ou une résine thermoplastique. Le matériau sera choisi de manière à ne pas être fusible sur la plage de température d'utilisation des composants électroniques. La résine peut être choisie parmi le groupe comprenant : les résines de type époxy, et les résines de type phénolique, les résines de type acrylique.

Le matériau isolant peut également comprendre des particules isolantes électriquement. Les particules sont, par exemple, des particules d'oxyde, et notamment des particules d'alumine ou de silice.

La polymérisation est, par exemple, une étape de polymérisation UV ou une polymérisation par activation thermique.

Un recuit peut être réalisé après l'étape c).

Lors de l'étape d), selon la première variante de réalisation, une partie de la première couche de matériau isolant 121 est retirée de manière à rendre accessible les plots conducteurs 117. Cette étape peut être réalisée au moyen d'une étape d'amincissement du matériau isolant 121 en face avant.

Lors de l'étape d), selon la deuxième variante de réalisation, une partie de la première couche de matériau isolant 121 est retirée de manière à rendre accessible les plages de connexion 107. Cette étape peut être réalisée au moyen d'une étape de gravure laser et éventuellement au moyen d'une étape d'amincissement du matériau isolant 121 en face avant. Les deux étapes (amincissement et gravure) peuvent être réalisées dans cet ordre ou dans l'ordre inverse.

La gravure laser conduit à la formation d'ouvertures dans la première couche de matériau isolant 121 sous forme de troncs de cône (figure 2D).

L'amincissement en face avant, mis en oeuvre lors de l'étape d), peut être réalisée par polissage ('grinding').

Lors de l'étape e), une couche de matériau conducteur 122 est déposée sur la couche de matériau isolant 121. La couche de matériau conducteur 122 est déposée de manière à relier les plages de connexion 107 de deux puces 100 adjacentes. Le matériau conducteur 122 forme un pont (ou jonction) entre les puces. La couche de matériau conducteur 122 est en contact avec la couche de matériau isolant 121. Autrement dit, il n'y a pas d'élément intermédiaire entre ces deux couches.

Le matériau conducteur 122 peut être en contact direct avec les plages de connexion 107 ou relié aux plages de connexion 107 via les plots conducteurs 117.

Le matériau conducteur 122 est, par exemple, un matériau brasable (ou soudable). Notamment, il s'agit d'étain ou d'un alliage à base d'étain, tel que SnAgCu. Il peut également s'agir d'un alliage de plomb ou d'un alliage d'antimoine. Il peut s'agir de SnPb ou SnSb.

Le matériau conducteur 122 peut contenir un flux de brasage.

Ce matériau peut être déposé par étalement d'une pâte, par exemple par sérigraphie à travers un pochoir dont les ouvertures sont positionnées en regard des plages de connexion et de la jonction à réaliser. Le pochoir est, par exemple, une feuille en inox ou en nickel pourvue d'ouvertures.

Le matériau conducteur brasable peut être soudé sur les plages de connexion 107 ou, le cas échéant, sur les plots conducteurs 117.

Lors de l'étape f), une deuxième couche de matériau isolant 123 est déposée sur le matériau conducteur 122 et sur la face avant des puces 100.

La première couche de matériau isolant 121 et la deuxième couche de matériau isolant 123 peuvent être en un même matériau. Par exemple, il s'agit d'une résine isolante, telle que l'une de celles décrites précédemment.

Une étape d'amincissement en face avant est ensuite réalisée pour rendre accessible le matériau conducteur 122 (étape g)). Ce matériau 122 forme en face avant, les contacts électriques (aussi appelés métallisations de connexion) du boîtier des composants 1000. Les contacts électriques en face avant permettent de connecter la puce à des éléments extérieurs 400.

L'amincissement peut être réalisé jusqu'à atteindre la hauteur de matériau conducteur désirée.

L'étape d'amincissement en face avant peut être réalisée par polissage ('grinding').

Le procédé peut également comprendre une étape d'amincissement du substrat 300 en face arrière 303. Pour cela, la structure est retournée et fixée par sa face avant 305 sur un support. Le support est, par exemple, une bande de ruban adhésif. La structure est, ensuite, amincie par sa face arrière 303 de façon que le substrat 300 ait son épaisseur définitive. Selon un exemple, la structure 301 est amincie jusqu'à atteindre le fond des cavités 307.

Le procédé peut avantageusement comprendre une étape additionnelle au cours de laquelle, une couche isolante additionnelle 124 est déposée sur la face arrière 303 de la structure pour former la partie arrière du boîtier des composants 1000. Ainsi, toutes les faces du substrat 300 sont protégées. La première couche isolante 121 forme les flancs du boîtier et au moins une partie de la face avant du boîtier. La couche additionnelle 124 forme la partie arrière du boîtier. La deuxième couche isolante 123 forme une autre partie de la face avant du boîtier.

La couche isolante additionnelle 124 est une couche en un matériau isolant électriquement. Le matériau isolant de la couche additionnelle 124 peut être identique au matériau isolant de la première couche 121 et/ou au matériau isolant de la deuxième couche 123. Selon un autre exemple, les matériaux des couches isolantes 121, 123, 124 sont différents. La couche isolante additionnelle 124 est, par exemple, une couche de résine.

Lors de l'étape h), les composants électroniques 1000 sont individualisés en réalisant une découpe à travers le matériau conducteur 122 et la première couche de résine isolante 121. La découpe est réalisée dans les cavités 307 ou dans les tranchées.

Les composants 1000 sont ainsi séparés les uns des autres.

Le matériau conducteur 122 est alors exposé, assurant la fonction de mouillabilité des flancs des composants électroniques 1000.

Le matériau conducteur 122 permet, en outre, une reprise directe de contact en face avant du boîtier, car il est relié/connecté aux plages de connexion électriques 107 de la puce 100.

Lors des étapes précédemment décrites, et notamment lors des étapes de découpe, la structure peut être positionnée sur un adhésif. L'adhésif utilisé peut être un adhésif sensible au rayonnement ultraviolet (UV) pour des applications de découpe (`UV dicing tape').

Les figures 1I, 2I et 3A illustrent, par une vue en coupe, partielle et schématique, un composant électronique 1000 à flancs mouillables obtenus par un tel procédé.

Le composant électronique 1000 comprend une puce électronique 100, formée dans un substrat 300, et un boîtier en matériau isolant protégeant la puce 100.

Le boîtier comprend au moins une première couche 121 en matériau isolant recouvrant les flancs du substrat 300 et une partie de la face supérieure 305 du substrat 300. Il peut en outre comprendre une deuxième couche 123 en matériau isolant recouvrant la partie de la première couche 121 positionnée sur la face supérieure 305 du substrat 300 et/ou une couche additionnelle 124 en matériau isolant recouvrant la face arrière 303 du substrat 300.

Le matériau conducteur forme, d'une part, les flancs mouillables du boîtier et d'autre part les métallisations en face avant du boîtier. Le matériau conducteur est, par exemple, encastré dans le boîtier. Il est relié ou connecté soit directement sur les plages de connexion 107 soit sur les plots métalliques 117 positionnés sur les plages de connexion 107. Il se prolonge à travers la première couche isolante 121, et le cas échéant à travers la deuxième couche isolante 123, jusqu'à la face supérieure du boîtier (pour permettre de connecter la puce 100 à un élément/dispositif extérieur 400) et d'autre part jusqu'au flancs du boîtier pour former les flancs mouillables du boîtier.

La couche de matériau conducteur 122 n'est pas directement en contact avec le substrat 300. La première couche en matériau isolant 121 est positionnée entre le substrat 300 et la couche 122 en matériau conducteur.

Les flancs du composant 1000 sont formés successivement du matériau isolant 121 et du matériau conducteur 122 (figures 1J, 2J, 3A) lorsque l'étape b) est mise en oeuvre. Lorsque l'étape b) n'est pas mise en oeuvre, les flancs du composant 1000 sont formés successivement par les flancs du substrat 300, le matériau isolant 121 et le matériau conducteur 122 (figure 4), autrement dit le matériau isolant 121 ne recouvre pas les flancs du substrat 300.

Le composant 1000 est un composant dit intégré.

Les composants 1000 obtenus sont des composants à montage en surface (ou SMD pour « surface mouting device ») de type "flip-chip", c'est-à-dire qu'ils peuvent être fixés sur un élément/dispositif externe 400, par exemple, une carte de circuit imprimé, par leur face supérieure, c'est-à-dire la face sur laquelle sont disposés les contacts du boîtier.

De tels composants 1000 sont particulièrement intéressants pour garantir la fiabilité des connexions électriques, une fois les circuits montés dans leur environnement. Ils permettent de visualiser facilement si le brasage du composant 1000 ('leadless component') sur un autre dispositif 400 a été réalisé correctement.

Les figures 3A et 3B représentent des étapes d'un procédé pour assembler un composant 1000 (`leadless component') sur un dispositif externe 400, par exemple une carte de circuit imprimé (ou PCB pour `printed circuit board') ou un autre composant.

Le dispositif externe 400 comprend un substrat 401 recouvert par des pistes 402. Les pistes 402 sont par exemple en cuivre. En particulier, les pistes 402 sont agencées, de manière à dépasser de la zone à laquelle le composant 1000 est fixé. Autrement dit, lorsque l'on observe l'assemblage (composant 1000 et dispositif externe 400, tel qu'un PCB), en vue de dessus, les pistes 402 sont visibles.

Un matériau de brasage 500 est positionné entre le composant 1000 et les pistes 402 du dispositif externe 400 (figure 3A). Lors du brasage, le matériau de brasage 500 remonte, non seulement, le long du matériau 122 formant les flancs mouillables des composants 1000, mais aussi sur les pistes 402 du dispositif externe 400 (figure 3B), ce qui permet de vérifier que le brasage a été réalisé correctement.

Le joint de soudure est visible en vue de dessus par inspection optique automatisée (AOI pour 'Automated Optical inspection').

L'utilisation de composants à flancs mouillables évite de devoir faire des contrôles aux rayons X ('X-ray') pour vérifier des PCB dits « double faces », c'est-à-dire avec des composants soudés sur les 2 faces.

De tels composants électroniques 1000 trouvent des applications dans de nombreux domaines industriels, et en particulier, dans le domaine automobile, pour l'électronique personnelle, notamment dans le domaine des équipements de communication, ordinateurs et périphériques.

Il peut, par exemple, s'agir des dispositifs de connexion 5G ou plus généralement des dispositifs connectés.

Il peut également s'agir de système avancé d'aide à la conduite (ADAS pour 'advanced driver-assistance systems').

La puce électronique peut être utilisée dans un smartphone ou pour l'internet des objet (IoT pour 'Internet of Things'). L'appareil est, par exemple, connecté par 5G, WIFI ou bande ultra-large (UWB pour `Ultra-Wide Band').

La puce peut également être intéressante pour d'autres domaines, comme par exemple pour le domaine industriel, notamment pour les énergies vertes.

De telles applications sont données à titre illustratif et ne sont pas limitatives.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication de composants électroniques (1000) à flancs mouillables comprenant les étapes suivantes :
a) fournir un substrat (300) dans lequel sont formées des puces (100), des plages de connexion (107) des puces (100) étant disposées sur une face supérieure (305) du substrat (300), des plots conducteurs (117) pouvant recouvrir les plages de connexion (107),
c) former une première couche de matériau isolant (121) sur le substrat (300), d) rendre accessible les plages de connexion (107) ou les plots conducteurs (117),
e) déposer une couche de matériau conducteur (122) sur la première couche de matériau isolant (121), la couche de matériau conducteur (122) étant en contact avec la première couche de matériau isolant (121), de manière à relier les plages de connexion (107) de deux puces adjacentes,
f) déposer une deuxième couche de matériau isolant (123) sur le matériau conducteur (122) et la face supérieure (305) du substrat (300),
g) amincir la deuxième couche de matériau isolant (123) jusqu'à rendre accessible le matériau conducteur (122),
h) séparer les puces (100) en découpant à travers la couche de matériau conducteur (122) et à travers la première couche de matériau isolant (121), moyennant quoi on obtient des composants électroniques (1000) à flancs mouillables.

2. Procédé selon la revendication 1, dans lequel, lors de l'étape a), les plages de connexion (107) sont recouvertes par des plots conducteurs (117) et dans lequel :
- l'étape c) est réalisée en déposant la première couche de matériau isolant (121) sur la face supérieure (305) du substrat (300) et sur les plots conducteurs (117),
- l'étape d) est réalisée en amincissant la première couche de matériau isolant (121) jusqu'à rendre accessible les plots conducteurs (117), et
- lors de l'étape e), la couche de matériau conducteur (122) est déposée sur les plots conducteurs (117).

3. Procédé selon la revendication 1, dans lequel :
- l'étape c) est réalisée en déposant la première couche de matériau isolant (121) sur la face supérieure (305) du substrat (300) et sur les plages de connexion (107),
- l'étape d) est réalisée en en gravant, et éventuellement en amincissant, la première couche de matériau isolant (121), pour rendre accessible les plages de connexion (107), et
- lors de l'étape e), la couche de matériau conducteur (122) est déposée sur les plages de connexion (107).

4. Procédé selon l'une des revendications 1 à 3, le procédé comprenant, avant l'étape g), une étape au cours de laquelle une face inférieure (303) du substrat (300) est amincie et est recouverte par une couche additionnelle de matériau isolant (124).

5. Procédé selon l'une des revendications 1 à 4, dans lequel la première couche de matériau isolant (121) et/ou la deuxième couche de matériau isolant (123) et/ou la couche additionnelle de matériau isolant (124) sont des couches de résine isolante, par exemple des couches de résine époxy.

6. Procédé selon l'une des revendications précédentes, dans lequel le procédé comprend une étape b), entre l'étape a) et l'étape c), au cours de laquelle des cavités (307) ou des tranchées sont formées entre les puces (100) à partir de la face supérieure (305) du substrat (300), lors de l'étape c), la première couche de matériau isolant (121) remplissant les cavités (307) ou les tranchées et recouvrant la face supérieure (305) du substrat (300).

7. Composant électronique (1000) à flancs mouillables comprenant une puce (100) formée dans un substrat (300), la puce (100) comprenant des plages de connexion (107) disposées sur une face supérieure (305) du substrat (300), une première couche de matériau isolant (121) recouvrant les flancs (304) du substrat (300) et la face supérieure (305) du substrat entre les plages de connexion (107), une deuxième couche de matériau isolant (123) recouvrant la première couche de matériau isolant (121) sur la face supérieure (305) du substrat (300), une couche de matériau conducteur (122) étant disposée sur chaque plage de connexion (107) et se prolongeant, d'une part, jusqu'à une face supérieure du composant électronique (1000), et, d'autre part, jusqu'à un flanc du composant électronique (1000),
les flancs du composant électronique (1000) étant formés du matériau isolant (121) et du matériau conducteur (122), ou les flancs du composant électronique (1000) étant formés du matériau isolant (121), du matériau conducteur (122) et du substrat (300).

8. Composant électronique (1000) selon la revendication 7, dans lequel une couche additionnelle de matériau isolant (124) recouvre une face inférieure (303) du substrat (300).

9. Composant électronique selon l'une des revendications 7 à 8, dans lequel la première couche de matériau isolant (121), la deuxième couche de matériau isolant (123) et/ou la couche additionnelle de matériau isolant (124) est une couche de résine époxy ou phénolique dans laquelle sont dispersées des charges électriquement isolantes, par exemple des particules d'alumine ou de silice.

10. Composant électronique selon l'une quelconque des revendications 7 à 9, dans lequel la couche de matériau conducteur (122) est une couche de matériau brasable, par exemple un matériau brasable à base d'étain, tel que SnAgCu.

11. Procédé d'assemblage d'un composant électronique (1000) selon l'une des revendications 7 à 10, avec un dispositif externe (400), tel qu'une carte de circuit imprimé, le procédé comprenant les étapes suivantes :
- positionner un matériau de brasage (500) entre le matériau conducteur (122) positionné sur la face supérieure du composant électronique (1000) et des éléments de connexion (402) du dispositif externe (400),
- braser le matériau de brasage (500), moyennant quoi le matériau de brasage (500) s'étale sur les éléments de connexion (401) du dispositif externe (400) et sur les flancs mouillables du composant électronique (1000).
